# EUROPÄISCHE PATENTANMELDUNG

(11) **EP 0 945 468 A2**
(43) Veröffentlichungstag der Anmeldung: **29.09.1999**
(21) Anmeldenummer: 99105590.6
(22) Anmeldetag: 18.03.1999
(51) Int. Cl.: C08F 2/50, G03F 7/029

(54) **Photoinitiatorgemische**

(30) Priorität: 24.03.1998 DE 19812859
(71) Anmelder: BASF AKTIENGESELLSCHAFT, 67056 Ludwigshafen (DE)
(72) Erfinder: Prantl, Bernhard, Dr., 67549 Worms (DE); Beck, Erich, Dr., 68526 Ladenburg (DE); Lokai, Matthias, 67677 Enkenbach-Alsenborn (DE); Kandzia, Christof Dr., 67157 Wachenheim (DE)

(57) **Zusammenfassung**

Photoinitiatormischung, enthaltend
a) mindestens ein Monoacylphosphinoxid der Formel I 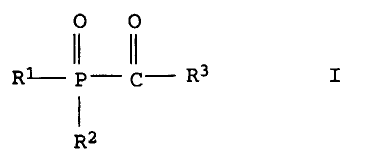 worin
   - R¹: C₁-C₁₈-Alkyl, durch Halogen oder C₁-C₆-Alkoxy substituiertes C₁-C₄-Alkyl, C₅-C₈-Cycloalkyl, C₇-C₉-Phenylalkyl, Phenyl, Naphthyl, Biphenyl, durch Halogen, C₁-C₁₂-Alkyl und/oder C₁-C₁₂-Alkoxy ein- oder mehrfach substituiertes Phenyl, Naphthyl oder Biphenylyl, oder einen einwertigen N-, O- oder S-haltigen 5- oder 6-gliedrigen heterocyclischen Rest bedeutet,
   - R²: Phenyl, Naphthyl, Biphenylyl, durch Halogen, C₁-C₁₂-Alkyl und/oder C₁-C₁₂-Alkoxy ein- oder mehrfach substituiertes Phenyl, Naphthyl oder Biphenylyl, einen einwertigen N-, O- oder S-haltigen 5- oder 6-gliedrigen heterocyclischen Rest, C₁-C₁₈-Alkoxy, Phenoxy, durch Halogen, C₁-C₄-Alkyl oder C₁-C₄-Alkoxy substituiertes Phenoxy, Benzyloxy, Cyclohexyloxy oder R² und R¹ zusammen mit dem Phosphoratom einen Ring bilden,
   - R³: C₁-C₁₈-Alkyl, durch Halogen oder C₁-C₆-Alkoxy substituiertes C₁-C₄-Alkyl, C₅-C₈-Cycloalkyl, C₇-C₉-Phenylalkyl, Phenyl, Naphthyl, Biphenylyl, durch Halogen, C₁-C₁₂-Alkyl und/oder C₁-C₁₂-Alkoxy ein- oder mehrfach substituiertes Phenyl, Naphthyl oder Biphenylyl, einen einwertigen N-, O- oder S-haltigen 5- oder 6-gliedrigen heterocyclischen Rest oder eine Gruppe 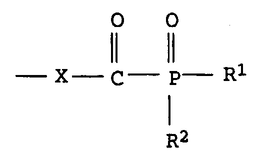 bedeutet, worin X C₂-C₈-Alkylen, Cyclohexylen oder unsubstituiertes oder durch Halogen, C₁-C₄-Alkyl oder C₁-C₄-Alkoxy substituiertes Phenylen oder Biphenylen bedeuten
b) mindestens ein Diacylphosphinoxid der Formel II 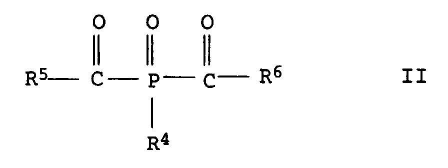 worin
   - R⁴: C₁-C₁₈-Alkyl, durch Halogen oder C₁-C₆-Alkoxy substituiertes C₁-C₄-Alkyl, C₅-C₈-Cycloalkyl, C₇-C₉-Phenylalkyl, Phenyl, Naphthyl, Biphenylyl, durch Halogen, C₁-C₁₂-Alkyl und/oder C₁-C₁₂-Alkoxy ein- oder mehrfach substituiertes Phenyl, Naphthyl oder Biphenylyl, einen einwertigen N-, O- oder S-haltigen 5- oder 6-gliedrigen heterocyclischen Rest, C₁-C₁₈-Alkoxy, Phenoxy, durch Halogen, C₁-C₄-Alkyl oder C₁-C₄-Alkoxy substituiertes Phenoxy, Benzyloxy, Cyclohexyloxy und
   - R⁵: und R⁶ unabhänig voneinander C₁-C₁₈-Alkyl, durch Halogen oder C₁-C₆-Alkoxy substituiertes C₁-C₄-Alkyl, C₅-C₈-Cycloalkyl, C₇-C₉-Phenylalkyl, Phenyl, Naphthyl, Biphenylyl, durch Halogen, C₁-C₁₂-Alkyl und/oder C₁-C₁₂-Alkoxy ein- oder mehrfach substituiertes Phenyl, Naphthyl oder Biphenylyl, einen einwertigen N-, O- oder S-haltigen 5- oder 6-gliedrigen heterocyclischen Rest
   bedeuten.

## Beschreibung

Die Erfindung betrifft eine Photoinitiatormischung, enthaltend
a) mindestens ein Monoacylphosphinoxid der Formel I 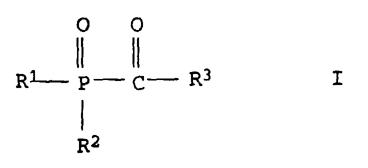 worin
   - R¹: C₁-C₁₈-Alkyl, durch Halogen oder C₁-C₆-Alkoxy substituiertes C₁-C₄-Alkyl, C₅-C₈-Cycloalkyl, C₇-C₉-Phenylalkyl, Phenyl, Naphthyl, Biphenyl, durch Halogen, C₁-C₁₂-Alkyl und/oder C₁-C₁₂-Alkoxy ein- oder mehrfach substituiertes Phenyl, Naphthyl oder Biphenylyl, oder einen einwertigen N-, O- oder S-haltigen 5- oder 6-gliedrigen heterocyclischen Rest bedeutet,
   - R²: Phenyl, Naphthyl, Biphenylyl, durch Halogen, C₁-C₁₂-Alkyl und/oder C₁-C₁₂-Alkoxy ein- oder mehrfach substituiertes Phenyl, Naphthyl oder Biphenylyl, einen einwertigen N-, O- oder S-haltigen 5- oder 6-gliedrigen heterocyclischen Rest, C₁-C₁₈-Alkoxy, Phenoxy, durch Halogen, C₁-C₄-Alkyl oder C₁-C₄-Alkoxy substituiertes Phenoxy, Benzyloxy, Cyclohexyloxy oder R² und R¹ zusammen mit dem Phosphoratom einen Ring bilden,
   - R³: C₁-C₁₈-Alkyl, durch Halogen oder C₁-C₆-Alkoxy substituiertes C₁-C₄-Alkyl, C₅-C₈-Cycloalkyl, C₇-C₉-Phenylalkyl, Phenyl, Naphthyl, Biphenylyl, durch Halogen, C₁-C₁₂-Alkyl und/oder C₁-C₁₂-Alkoxy ein- oder mehrfach substituiertes Phenyl, Naphthyl oder Biphenylyl, einen einwertigen N-, O- oder S-haltigen 5- oder 6-gliedrigen heterocyclischen Rest oder eine Gruppe 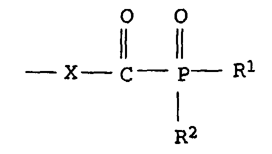 bedeutet, worin X C₂-C₈-Alkylen, Cyclohexylen oder unsubstituiertes oder durch Halogen, C₁-C₄-Alkyl oder C₁-C₄-Alkoxy substituiertes Phenylen oder Biphenylen bedeuten
b) mindestens ein Diacylphosphinoxid der Formel II 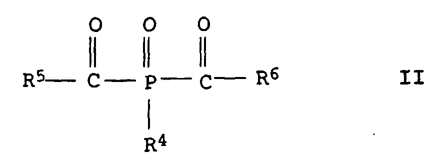 worin
   - R⁴: C₁-C₁₈-Alkyl, durch Halogen oder C₁-C₆-Alkoxy substituiertes C₁-C₄-Alkyl, C₅-C₈-Cycloalkyl, C₇-C₉-Phenylalkyl, Phenyl, Naphthyl, Biphenylyl, durch Halogen, C₁-C₁₂-Alkyl und/oder C₁-C₁₂-Alkoxy ein- oder mehrfach substituiertes Phenyl, Naphthyl oder Biphenylyl, einen einwertigen N-, O- oder S-haltigen 5- oder 6-gliedrigen heterocyclischen Rest, C₁-C₁₈-Alkoxy, Phenoxy, durch Halogen, C₁-C₄-Alkyl oder C₁-C₄-Alkoxy substituiertes Phenoxy, Benzyloxy, Cyclohexyloxy und
   - R⁵: und R⁶ unabhängig voneinander C₁-C₁₈-Alkyl, durch Halogen oder C₁-C₆-Alkoxy substituiertes C₁-C₄-Alkyl, C₅-C₈-Cyclo-alkyl, C₇-C₉-Phenylalkyl, Phenyl, Naphthyl, Biphenylyl, durch Halogen, C₁-C₁₂-Alkyl und/oder C₁-C₁₂-Alkoxy ein-oder mehrfach substituiertes Phenyl, Naphthyl oder Biphenylyl, einen einwertigen N-, O- oder S-haltigen 5- oder 6-gliedrigen heterocyclischen Rest
   bedeuten.

Des weiteren betrifft die Erfindung strahlungshärtbare Massen, welche die Photoinitiatorgemische enthalten.

Monoacylphosphinoxide sind z.B. aus EP-A-7508 und EP-7086; Diacylphosphinoxide aus EP-A-184 095 und DE-A-19 708 294 bekannt.

Photoinitiatormischungen, welche Acylphosphinoxide enthalten, sind z.B. in EP 446 175 beschrieben.

An Photoinitiatoren, welche in strahlungshärtbaren Massen Verwendung finden, werden eine Vielzahl von Anforderungen gestellt. Von besonderer Bedeutung ist eine hohe Reaktivität der Photoinitiatoren, worunter zum einen eine schnelle Aushärtung zum anderen die Aushärtung auch von dicken Schichten bis in die unteren Lagen zu verstehen ist.

Des weiteren sollen die Photoinitiatoren nicht zu einer Vergilbung der strahlungshärtbaren Monen, bzw. der daraus hergestellten Beschichtungen führen.

Um die verschiedenen Anforderungen zu erfüllen, werden auch Gemische von Photoinitiatoren verwendet. Voraussetzung dazu ist, daß die Photoinitiatoren über einen möglichst breiten Mischungsbereich gut mischbar sind.

Bisher bekannte Photoinitiatoren und Photoinitiatorgemische erfüllen die vielfältigen Anforderungen noch nicht im gewünschten Maß.

Aufgabe der vorliegenden Erfindung war, ausgehend von bekannten Photoinitiatoren, Photoinitiatorgemische zur Verfügung zu stellen, welche lagerstabil, problemlos mischbar und verarbeitbar sind und Anforderungen, wie eine hohe Reaktivität, geringe Vergilbung, Aushärtung auch dicker und pigmentierter Schichten gut erfüllen.

Demgemäß wurde das eingangs definierte Photoinitiatorgemisch und strahlungshärtbare Massen, welche dieses Photoinitiatorgemisch enthalten, gefunden.

Die erfindungsgemäße Photoinitiatormischung enthält je mindestens ein Monoacylphosphinoxid der Formel I und ein Diacylphosphinoxid der Formel II.

In Formel I steht R¹ bevorzugt für Phenyl oder eine durch Halogen, C₁-C₁₂-Alkyl oder durch C₁-C₁₂-Alkoxy ein oder mehrfach substituierte Phenylgruppe.

Besonders bevorzugt steht R¹ für Phenyl oder eine durch 1 bis 3 C₁-C₄-Alkylgruppen substituierte Phenylgruppe. Bei den Alkylgruppen handelt es sich insbesondere um Methylgruppen.

Ganz besonders bevorzugt handelt es sich um Phenyl
- R²: steht bevorzugt für Phenyl, Phenoxy, eine durch Halogen, C₁-C₁₂-Alkyl oder eine C₁-C₁₂-Alkoxygruppe ein oder mehrfach substituierte Phenylgruppe bzw. Phenoxygruppe oder eine C₁-C₁₈-Alkoxygruppe.
Besonders bevorzugt steht R² für Phenyl, Phenoxy eine durch 1 bis 3 Alkylgruppen, insbesondere Methylgruppen, substituierte Phenylgruppe bzw. Phenoxygruppe oder für eine C₁-C₈-Alkoxygruppe.
Ganz besonders bevorzugt steht R² für eine C₁ - C₈ Alkoxygruppe, insbesondere eine c₁ - C₄ Alkoxygruppe
- R³: steht bevorzugt für Phenyl oder eine durch Halogen, C₁-C₁₂-Alkyl oder C₁-C₁₂-Alkoxy ein oder mehrfach substituierte Phenylgruppe.

Besonders bevorzugt steht R³ für eine Phenylgruppe, welche mindestens in 2 und 6, 2 und 4 oder in 2, 4 und 6 Position (zur Carbonylgruppe) durch eine C₁-C₈-Alkylgruppe, vorzugsweise eine C₁-C₃-Alkylgruppe, insbesondere eine Methylgruppe, substituiert ist.

Ganz besonders bevorzugt steht R³ für eine 2,4-Dimethylphenyl- oder eine 2,4,6-Trimethylphenylgruppe.

In Formel II steht R⁴ bevorzugt für Phenyl, Phenoxy, eine durch Halogen, C₁-C₁₂-Alkyl oder C₁-C₁₂-Alkoxy ein oder mehrfach substituierte Phenylgruppe bzw. Phenoxygruppe oder eine C₁-C₁₈-Alkoxygruppe oder eine C₁ - C₁₈ Alkylgruppe.

Besonders bevorzugt steht R⁴ für Phenyl, Phenoxy oder eine durch 1 bis 3 C₁-C₄-Alkylgruppen substituierte Phenylgruppe. Bei den Alkylgruppen handelt es sich insbesondere um Methylgruppen.

Ganz besonders bevorzugt steht R⁴ für Phenyl.
- R⁵: und R⁶ stehen bevorzugt unabhängig voneinander für Phenyl oder eine durch Halogen, C₁-C₁₂-Alkyl oder C₁-C₁₂-Alkoxy ein oder mehrfach substituierte Phenylgruppe.

Besonders bevorzugt stehen R⁵ und R⁶ unabhängig voneinander für eine in 2 und 6, 2 und 4 und 2, 4 und 6 Position (zur Carbonylgruppe) durch C₁-C₈, vorzugsweise C₁ - C₄, Alkoxy- oder Alkylsubstituierte Phenylgruppe.

Ganz besonders bevorzugt stehen R⁵ und R⁶ für eine 2,4-Dimethylphenylgruppe des insbesondere eine 2, 4, 6 Trimethylphenylgruppe.

Bevorzugte Monoacylphosphinoxide der Formel I sind insbesondere:
Ia: R¹, R² = Phenyl, R³ = 2,4,6 Trimethylphenyl
Ib: R¹ = Phenyl, R² = Ethoxy, R³ = 2,4,6 Trimethlphenyl
Ic: R¹ = Phenyl, R² = Propoxy, R3 = 2,4,6 Trimethylphenyl
Id: R¹ = Phenyl, R² = Butoxy, R³ = 2,4,6 Trimethylphenyl

Bevorzugte Diacylphosphinoxide der Formel II sind insbesondere:
IIa:R⁴ = Phenyl, R⁵, R⁶, = 2,4,6 Trimethylphenyl
IIb:R⁴ = Phenoxy, R⁵, R⁶ = 2,4,6 Trimethylphenyl
IIc:R⁴ = C₁ -C₄ Alkyl, R⁵, R⁶ = 2,4,6 Trimethylphenyl
IIe:R⁴ = Propoxy, R⁵, R⁶ = 2,4,6 Trimethylphenyl
IIf:R⁴ = Butoxy, R⁵, R⁶ = 2,4,6 Trimethylphenyl

Die Monoacylphosphinoxide der Formel I sind vorzugsweise bei 21°C (1 bar) flüssig.

Die Diacylphosphinoxide der Formel II sind im allgemeinen fest bei 21°C.

Das Gemisch ist vorzugsweise flüssig. Der Anteil der Monoacylphosphinoxide a) beträgt vorzugsweise 70 bis 98 Gew. -%, besonders bevorzugt 75 bis 95 Gew.-% und ganz besonders bevorzugt 80 bis 90 Gew.-%, bezogen auf die Gewichtssumme aus a) + b).

Der Anteil der Diacylphosphinoxide beträgt entsprechend vorzugsweise 2 bis 30 Gew.-%, besonders bevorzugt 5 bis 25 Gew.-% und ganz besonders bevorzugt 10 bis 20 Gew.-%, bezogen auf die Gewichtssumme aus a) + b).

Die Herstellung des erfindungsgemäßen Photoinitiatorgemisches kann in einfacher Weise durch Mischen der Verbindungen a) und b) in beliebiger Reihenfolge erfolgen.

Insbesondere können die Diacylphosphinoxide in den Monoacylphosphinoxiden gelöst werden, oder sowohl die Mono-und Diacylphosphinoxide einzeln oder gemeinsam in einem Lösungsmittel, z.B. Aceton gelöst werden und das Lösungsmittel nach dem Mischen der Phospinoxide abdestilliert werden.

Die erfindungsgemäße Photoinitiatormischung wird insbesondere als Photoinitiator für die Strahlungshärtung von radikalisch polymerisierbaren, ethylenisch ungesättigten Verbindungen verwendet.

Das Gemisch, welches die erfindungsgemäße Photoinitiatormischung und mindestens eine polymerisierbare, ethylenisch ungesättigte Verbindung enthält, wird im nachfolgenden auch strahlungshärtbare Masse genannt.

Als strahlungshärtbare, radikalisch polymerisierbare Verbindungen kommen Verbindungen mit nur einer ethylenisch ungesättigten, copolymerisierbaren Gruppe in Betracht (Verbindungen A).

Genannt seien z.B. C₁-C₂₀-Alkyl (meth) acrylate, Vinylaromaten mit bis zu 20 C-Atomen, Vinylester von bis zu 20 C-Atomen enthaltenden Carbonsäuren, ethylenisch ungesättigten Nitrile, Vinylether von 1 bis 10 C-Atome enthaltenden Alkoholen und aliphatischen Kohlenwasserstoffen mit 2 bis 8 C-Atomen und 1 oder 2 Doppelbindungen.

Als (Meth)acrylsäurealkylester bevorzugt sind solche mit einem C₁-C₁₀-Alkylrest, wie Methylmethacrylat, Methylacrylat, n-Butylacrylat, Ethylacrylat und 2-Ethylhexylacrylat.

Insbesondere sind auch Mischungen der (Meth)acrylsäurealkylester geeignet.

Vinylester von Carbonsäuren mit 1 bis 20 C-Atomen sind z.B. Vinyllaurat, -stearat, Vinylpropionat und Vinylacetat.

Als vinylaromatische Verbindungen kommen z.B. Vinyltoluol, α-Butylstyrol, 4-n-Butylstyrol, 4-n-Decylstyrol und vorzugsweise Styrol in Betracht.

Beispiele für Nitrile sind Acrylnitril und Methacrylnitril.

Geeignete Vinylether sind z.B. Vinylmethylether, Vinylisobutylether, Vinylhexyl- und -octylether.

Als nicht aromatische Kohlenwasserstoffe mit 2 bis 8 C-Atomen und eine oder zwei olefinischen Doppelbindungen seien Butadien, Isopren, sowie Ethylen, Propylen und Isobutylen genannt.

Bevorzugte strahlungshärtbare, radikalisch polymerisierbare Verbindungen sind solche mit mehreren polymerisierbaren, ethylenisch ungesättigten Gruppen (Verbindungen B).

Insbesondere handelt es sich bei Verbindungen B) um (Meth)acrylatverbindungen, bevorzugt sind jeweils die Acrylatverbindungen, d.h. die Derivate der Acrylsäure.

Bevorzugte (Meth)acrylat-Verbindungen B) enthalten 2 bis 20, bevorzugt 2 bis 10 und ganz besonders bevorzugt 2 bis 6 copolymerisierbare, ethylenisch ungesättigte Doppelbindungen.

Das zahlenmittlere Molekulargewicht Mₙ der (Meth)acrylatverbindungen B) liegt bevorzugt unter 15000, besonders bevorzugt unter 5000, ganz besonders bevorzugt unter 3000 g/mol und über 180 g/mol (bestimmt durch Gelpermeationschromatographie mit Polystyrol als Standard und Tetrahydrofuran als Elutionsmittel).

Als (Meth)acrylatverbindungen genannt seien (Meth)acrylsäureester und insbesondere Acrylsäureester von mehrfunktionellen Alkoholen, insbesondere solchen, die neben den Hydroxylgruppen keine weiteren funktionellen Gruppen oder allenfalls Ethergruppen enthalten. Beispiele solcher Alkohole sind z.B. bifunktionelle Alkohole, wie Ethylenglykol, Propylenglykol, und deren hoher kondensierte Vertreter, z.B. wie Diethylenglykol, Triethylenglykol, Dipropylenglykol, Tripropylenglykol etc., Butandiol, Pentandiol, Hexandiol, Neopentylglykol, alkoxylierte phenolische Verbindungen, wie ethoxylierte bzw. propoxylierte Bisphenole, Cyclohexandimethanol, trifunktionelle und höherfunktionelle Alkohole, wie Glycerin, Trimethylolpropan, Butantriol, Trimethylolethan, Pentaerythrit, Ditrimethylolpropan, Dipentaerythrit, Sorbit, Mannit und die entsprechenden alkoxylierten, insbesondere ethoxy- und propoxylierte Alkohole.

Die Alkoxylierungsprodukte sind in bekannter Weise durch Umsetzung der vorstehenden Alkohole mit Alkylenoxiden, insbesondere Ethylen- oder Propylenoxid, erhältlich. Vorzugsweise beträgt der Alkoxylierungsgrad je Hydroxylgruppe 0 bis 10, d.h. 1 mol Hydroxylgruppe kann vorzugsweise mit bis zu 10 mol Alkylenoxiden alkoxyliert sein.

Als (Meth)acrylatverbindungen seien weiterhin Polyester(meth)acrylate genannt, wobei es sich um die (Meth)Acrylsäureester von Polyesterolen handelt.

Als Polyesterole kommen z.B. solche in Betracht, wie sie durch Veresterung von Polycarbonsäuren, vorzugsweise Dicarbonsäuren, mit Polyolen, vorzugsweise Diolen, hergestellt werden können. Die Ausgangsstoffe für solche hydroxylgruppenhaltige Polyester sind dem Fachmann bekannt. Bevorzugt können als Dicarbonsäuren Bernsteinsäure, Glutarsäure, Adipinsäure, Sebacinsäure, o-Phthalsäure, deren Isomere und Hydrierungsprodukte sowie veresterbare Derivate, wie Anhydride oder Dialkylester der genannten Säuren eingesetzt werden. Als Polyole kommen die oben genannten Alkohole, vorzugsweise Ethylenglykol, Propylenglykol-1,2 und -1,3, Butandiol-1,4, Hexandiol-1,6, Neopentylglykol, Cyclohexandimethanol sowie Polyglykole vom Typ des Ethylenglykols und Propylenglykols in Betracht.

Polyester(meth)acrylate können in mehreren Stufen oder auch einstufig, wie z.B. in EP 279 303 beschrieben, aus Acrylsäure, Polycarbonsäure, Polyol hergestellt werden.

Weiterhin kann es sich bei Verbindungen B) z.B. um Epoxid- oder Urethan(meth)acrylate handeln.

Epoxid(meth)acrylate sind z.B. solche wie sie durch Umsetzung von epoxidierten Olefinen oder Poly- bzw. Mono- oder Diglycidylethern, wie Bisphenol-A-diglycidylether, mit (Meth)acrylsäure erhältlich sind.

Die Umsetzung ist dem Fachmann bekannt und z.B. in R. Holmann, U.V. and E.B. Curing Formulation for Printing Inks and Paints, London 1984, beschrieben.

Bei Urethan(meth)acrylaten handelt es sich insbesondere um Umsetzungsprodukte von Hydroxyalkyl(meth)acrylaten mit Poly- bzw. Diisocyanaten (s. ebenfalls R. Holmann, U.V. and E.B. Curing Formulation for Printing Inks and Paints, London 1984).

Es können natürlich auch Mischungen verschiedener Verbindungen B), insbesondere auch Mischungen der obigen (Meth)acrylverbindungen, eingesetzt werden.

Als strahlungshärtbare Verbindungen B) kommen z.B. auch ungesättigte Polyesterharze in Betracht, welche im wesentlichen aus Polyolen, insbesondere Diolen, und Polycarbonsäuren, insbesondere Dicarbonsäuren, bestehen, wobei eine der Veresterungskomponenten eine copolymerisierbare, ethylenisch ungesättigte Gruppe enthält. Z.B. handelt es sich dabei um Maleinsäure, Fumarsäure oder Maleinsäureanhydrid.

Bevorzugte strahlungshärtbare Verbindungen sind die Meth(acrylat)verbindungen B).

Verbindungen B) werden oft im Gemisch mit Verbindungen A), welche z.B. als Reaktivverdünner dienen, verwendet.

Bevorzugte strahlungshärtbare Massen enthalten mindestens 40 Gew.-%, besonders bevorzugt mindestens 60 Gew.-% der Verbindungen B), insbesondere der (Meth)acrylverbindungen B), bezogen auf die Gesamtmenge aus Verbindungen A)+B).

Die strahlungshärtbaren Massen enthalten vorzugsweise 0,05 bis 15, besonders bevorzugt 0,1 bis 7, ganz besonders bevorzugt 0,1 bis 5 Gew.-Teile des erfindungsgemäßen Photoinitiatormischung, bezogen auf 100 Gew.-Teile der polymerisierbaren, ethylenisch ungesättigten Verbindungen (Verbindungen A)+B)).

Neben der erfindungsgemäßen Photoinitiatormischung können weitere Photoinitiatoren mitverwendet werden. In Betracht kommen z.B. Benzophenon, Benzophenonderivate, Hydroxyacetophenon, Hydroxyacetophenonderivate ect. Die vorstehend angegebenen Mengen an Photoinitiator werden dabei im allgemeinen nicht überschritten.

Vorteilhafterweise können die strahlungshärtbaren Massen Aminoverbindungen enthalten, welche als Beschleuniger wirken.

Es kann sich dabei um primäre, sekundäre oder tertiäre Aminverbindungen handeln. Primäre oder sekundäre Aminoverbindungen addieren sich durch eine Michael-Addition z.B. an die Doppelbindungen der (Meth)acrylverbindungen B).

Bevorzugt beträgt der Gehalt an Aminoverbindungen 0,01 bis 3 Gew.-Teile Stickstoff, besonders bevorzugt 0,05 bis 1 Gew.-Teil Stickstoff, bezogen auf 100 Gew.-Teile strahlungshärtbare Verbindungen A) + B).

Die strahlungshärtbaren Massen können z.B. Pigmente, Farbstoffe, Verkaufshilfsmittel, Stabilisatoren weitere Photoinitiatoren etc. enthalten. Bei pigmentierten strahlungshärtbaren Massen treten die Vorteile der erfindungsgemäßen Photoinitiatormischung besonders deutlich hervor.

Als weitere, zusätzliche Photoinitiatoren können z.B. Anthrachinon und dessen Derivate z.B. β-Methylanthrachinon oder tert.-Butylanthrachinon oder Benzoine verwendet werden.

Der Pigmentgehalt kann z.B. 5 bis 70 Gew.-Teile, vorzugsweise 10 bis 50 Gew.-Teile Pigmente, bezogen auf 100 Gew.-Teile strahlungshärtbare Verbindungen A) + B) betragen.

Die strahlungshärtbaren Massen können als Beschichtungsmassen, z.B. als Lack oder Druckfarbe oder zur Herstellung von Formkörpern, z.B. Druckplatten, Photoresisten oder Reliefformen, wie sie z.B. über das Sterolithographieverfahren erhalten werden, sowie zur Herstellung von faserverstärkten Verbundstoffen, verwendet werden.

Des weiteren können die photopolymerisierbaren Massen als Fülloder Spachtelmassen Verwendung finden. Für diese Verwendung sind insbesondere auch die oben genannten Massen auf Basis ungesättigter Polyester oder (Poly)Epoxid(meth)acrylate geeignet.

Eine weitere Verwendungsmöglichkeit sind Dentalmassen, z.B. als Zahnfüllmassen oder Zahnersatzkörper.

Die strahlungshärtbaren Massen werden insbesondere durch Bestrahlung mit UV-Licht gehärtet. Die Härtung kann z.B. auch durch Tageslicht erfolgen.

Als Strahlungsguellen geeignet sind z.B. Quecksilber-Niederdruckstrahlen, -Mitteldruckstrahler mit Hochdruckstrahler sowie Leuchtstoffröhren, Impulsstrahler, Metallhalogenidstrahler, Elektronenblitzeinrichtungen oder Excimerstrahler.

Die erfindungsgemäßen, strahlungshärtbaren Massen sind lagerstabil und zeigen eine gute und schnelle Härtung beim Bestrahlen. Auch dicke oder pigmentierte Beschichtungen können bis in die unteren Schichten leicht ausgehärtet werden.

Die erfindungsgemäße Photoinitiatormischung führt zu keinen Geruchsbelästigungen. Sie ist vorzugsweise flüssig und daher gut zu handhaben.

### Beispiele

### Beispiele 1-4

70 Teile des aminmodifizierten Polyetheracrylates Laromer® LR 8894 (BASF AG) werden mit 30 Teilen Titandioxid des Rutiltyps, 4,5 Teilen einer Mischung von Trimethylbenzophenon mit Monomethylbenzophenon (Esacure TZT, Fa. Fratelli Lamberti) und mit je 1,6 Teilen der in der Tabelle aufgelisteten Phosphinoxid-Fotoinitiatoren und Fotoinitiatormischungen mit einem Dispermaten 15 Minuten unter Lichtschutz abgemischt.

Im Falle der festen Initiatoren werden diese zur besseren Einarbeitung in der etwa dreifachen Menge Aceton vorgelöst.

Die Mischungen werden zu 12 µm dicken Filmen auf Polyethylenfolie aufgerakelt. Die Aceton enthaltenden Filme werden 5 Minuten bei Raumtemperatur abgelüftet.

Zur Bestimmung der Reaktivität werden die Filme auf einem Band im Abstand 15 cm unter einer W/cm Quecksilberhochdrucklampe der Leistung 120 W/cm vorbeigeführt. Die Geschwindigkeit des Bandes bestimmt die Belichtungszeit der Filme. Die Bandgeschwindigkeit zur Durchhärtung ist dadurch ein Maß für die Reaktivität des Flüssigfilmes. Die Durchhärtung der Filme wird durch Kratzen mit dem Fingernagel bestimmt.

### Ergebnisse

| Versuchs-Nr. | 1 | 2 | 3 | 4 |
|---|---|---|---|---|
| Phosphinoxid-Initiator | | BAPO | TPO-L | 85 % TPO-L |
| | | | | 15 % BAPO |
| Zustand der Phosphinoxide | | fest | flüssig | flüssig |
| Kristallisation nach 90 Tage -Lagerung bei 3°C | | - | nein | nein |
| Hilfslösemittel zur Einarbeitung | | mit | ohne | ohne |
| Reaktivität (m/min) | 7 | 70 | 45 | 75 |
| TPO-L: 2,4,6-Trimethylbenzoylethoxyphenylphosphinoxid BAPO: Bis-(2,4,6-trimethylbenzoyl)-phenylphosphinoxid | | | | |

### Beispiel 5

80 Teile des aminmodifizierten Polyetheracrylates Laromer PO 84 F (BASF AG) werden mit 20 Teilen Titandioxid des Rutiltyps, 2 Teilen des Dispergierhilfsmittels Disperbyk 110 (Fa. Byk) und mit je 0,5 Teilen einer Mischung von 85 % TPO-L und 15 % (Lucinin® TPO: 2,4,6-Trimetylbenzoylbisphenylphosphinoxid) mit einem Dispermaten 15 Minuten unter Lichtschutz abgemischt.

Die Mischungen werden in einem 1 cm hohen Gefäß eingefüllt und bei 5 m/min mit 2 Quecksilberhochdruckstrahlern bei einem Lampenabstand von 15 cm belichtet. Die gehärtete Schicht wird mit Ethylacetat gewaschen. Als durchgehärtete Schichtdicke wird 210 µm bestimmt. Damit ist die durchgehärtete Schicht etwa doppelt so dick wie zum Erreichen einer Opazität (keine Transluzenz mehr) notwendig.

## Patentansprüche

1. Photoinitiatormischung, enthaltend
a) mindestens ein Monoacylphosphinoxid der Formel I 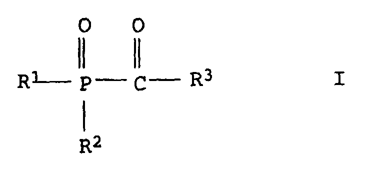 worin
R¹ C₁-C₁₈-Alkyl, durch Halogen oder C₁-C₆-Alkoxy substituiertes C₁-C₄-Alkyl, C₅-C₈-Cycloalkyl, C₇-C₉-Phenylalkyl, Phenyl, Naphthyl, Biphenyl, durch Halogen, C₁-C₁₂-Alkyl und/oder C₁-C₁₂-Alkoxy ein- oder mehrfach substituiertes Phenyl, Naphthyl oder Biphenylyl, oder einen einwertigen N-, O- oder S-haltigen 5- oder 6-gliedrigen heterocyclischen Rest bedeutet,
R² Phenyl, Naphthyl, Biphenylyl, durch Halogen, C₁-C₁₂-Alkyl und/oder C₁-C₁₂-Alkoxy ein- oder mehrfach substituiertes Phenyl, Naphthyl oder Biphenylyl, einen einwertigen N-, O- oder S-haltigen 5- oder 6-gliedrigen heterocyclischen Rest, C₁-C₁₈-Alkoxy, Phenoxy, durch Halogen, C₁-C₄-Alkyl oder C₁-C₄-Alkoxy substituiertes Phenoxy, Benzyloxy, Cyclohexyloxy oder R² und R¹ zusammen mit dem Phosphoratom einen Ring bilden,
R³ C₁-C₁₈-Alkyl, durch Halogen oder C₁-C₆-Alkoxy substituiertes C₁-C₄-Alkyl, C₅-C₈-Cycloalkyl, C₇-C₉-Phenylalkyl, Phenyl, Naphthyl, Biphenylyl, durch Halogen, C₁-C₁₂-Alkyl und/oder C₁-C₁₂-Alkoxy ein- oder mehrfach substituiertes Phenyl, Naphthyl oder Biphenylyl, einen einwertigen N-, O- oder S-haltigen 5- oder 6-gliedrigen heterocyclischen Rest oder eine Gruppe 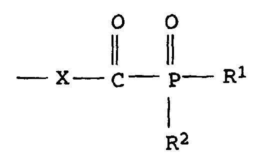 bedeutet, worin X C₂-C₈-Alkylen, Cyclohexylen oder unsubstituiertes oder durch Halogen, C₁-C₄-Alkyl oder C₁-C₄-Alkoxy substituiertes Phenylen oder Biphenylen bedeuten
b) mindestens ein Diacylphosphinoxid der Formel II 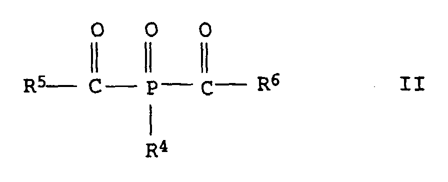 worin
R⁴ C₁-C₁₈-Alkyl, durch Halogen oder C₂-C₆-Alkoxy substituiertes C₁-C₄-Alkyl, C₅-C₈-Cycloalkyl, C₇-C₉-Phenylalkyl, Phenyl, Naphthyl, Biphenylyl, durch Halogen, C₁-C₁₂-Alkyl und/oder C₁-C₁₂-Alkoxy ein- oder mehrfach substituiertes Phenyl, Naphthyl oder Biphenylyl, einen einwertigen N-, O- oder S-haltigen 5- oder 6-gliedrigen heterocyclischen Rest, C₁-C₁₈-Alkoxy, Phenoxy, durch Halogen, C₁-C₄-Alkyl oder C₁-C₄-Alkoxy substituiertes Phenoxy, Benzyloxy, Cyclohexyloxy und
R⁵ und R⁶ unabhängig voneinander C₁-C₁₈-Alkyl, durch Halogen oder C₁-C₆-Alkoxy substituiertes C₁-C₄-Alkyl, C₅-C₈-Cycloalkyl, C₇-C₉-Phenylalkyl, Phenyl, Naphthyl, Biphenylyl, durch Halogen, C₁-C₁₂-Alkyl und/oder C₁-C₁₂-Alkoxy ein- oder mehrfach substituiertes Phenyl, Naphthyl oder Biphenylyl, einen einwertigen N-, O- oder S-haltigen 5- oder 6-gliedrigen heterocyclischen Rest
bedeuten.

2. Photoinitiatormischung gemäß Anspruch 1, wobei
R¹ für Phenyl oder eine durch Halogen, C₁-C₁₂-Alkyl oder durch C₁-C₁₂-Alkoxy ein oder mehrfach substituierte Phenylgruppe,
R² für Phenyl, eine durch Halogen, C₁-C₁₂-Alkyl oder C₁-C₁₂-Alkoxy ein oder mehrfach substituierte Phenylgruppe oder eine C₁-C₁₈-Alkoxygruppe und
R³ für Phenyl oder eine durch Halogen, C₁-C₁₂-Alkyl oder C₁-C₁₂-Alkoxy ein oder mehrfach substituierte Phenylgruppe steht.

3. Photoinitiatormischung gemäß Anspruch 2, wobei
R¹ für Phenyl oder eine durch 1 bis 3 Methylgruppen substituierte Phenylgruppe,
R² für Phenyl, Phenoxy, eine durch Methyl ein oder mehrfach substituierte Phenylgruppe bzw. Phenoxygruppe oder eine C₁-C₈-Alkoxygruppe und
R³ für eine 2,4,6 Trimethylphenyl- oder eine 2,4-Dimethylphenylgruppe
steht.

4. Photoinitiatormischung gemäß einem der Ansprüche 1 bis 3, wobei
R⁴ für Phenyl, Phenoxy, eine durch Halogen, C₁-C₁₂-Alkyl oder C₁-C₁₂-Alkoxy ein- oder mehrfach substituierte Phenylgruppe bzw. Phenoxygruppe oder eine C₁-C₁₈-Alkoxygruppe oder eine C₁-C₁₈-Alkylgruppe
R⁵ und R⁶ unabhängig voneinander für Phenyl oder eine durch Halogen, C₁-C₁₂-Alkyl oder C₁-C₁₂-Alkoxy ein oder mehrfach substituierte Phenylgruppe stehen.

5. Photoiniatormischung gemäß Anspruch 4, wobei
R⁴ für Phenyl, eine durch Methyl ein oder mehrfach substituierte Phenylgruppe und
R⁵ und R⁶ für eine 2,4-Dimethylphenyl- oder eine 2,4,6 Trimethylphenylgruppe stehen.

6. Photoinitiatormischung gemäß einem der Ansprüche 1 bis 5, wobei die Monoacylphosphinoxide a) flüssig sind.

7. Photoinitiatormischung gemäß einem der Ansprüche 1 bis 6, wobei der Anteil der Monoacylphosphinoxide a) 70 bis 98 Gew.-% und der Diacylphosphinoxide b) 2 bis 30 Gew.-%, bezogen auf die Summe a) + b) beträgt.

8. Strahlungshärtbare Masse, enthaltend mindestens eine polymerisierbare ethylenisch ungesättigte Verbindung und eine Photoinitiatormischung gemäß einem der Ansprüche 1 bis 7.

9. Strahlungshärtbare Masse gemäß Anspruch 8, enthaltend 0,05 bis 15 Gew.-Teile der Photoinitiatormischung gemäß einem der Ansprüche 1 bis 7, bezogen auf 100 Gew.-Teile polymerisierbare, ethylenisch ungesättigte Verbindungen.
